# EUROPEAN PATENT APPLICATION

(11) **EP 2 148 361 A1**
(43) Date of publication of application: **27.01.2010**
(21) Application number: 08752426.0
(22) Date of filing: 08.05.2008
(51) Int. Cl.: H01L 21/3065, C23C 4/10

(54) **DRY ETCHING APPARATUS AND DRY ETCHING METHOD**

(30) Priority: 11.05.2007 JP 2007126442
(71) Applicant: Ulvac, Inc., Chigasaki-shi Kanagawa 253-8543 (JP)
(72) Inventor: MORIKAWA, Yasuhiro, Susono-shi Shizuoka 410-1231 (JP); SUU, Koukou, Susono-shi Shizuoka 410-1231 (JP); HAYASHI, Toshio, Susono-shi Shizuoka 410-1231 (JP)
(74) Representative: Epping - Hermann - Fischer
(86) International application number: PCT/JP2008/058535
(87) International publication number: WO 2008/140012

(57) **Abstract**

A dry etching apparatus having excellent in-plane uniformity and a high etching rate and a dry etching method are provided. A dry etching apparatus includes a vacuum chamber having an upper plasma generation chamber and a lower substrate processing chamber; a magnetic field coil disposed outside a sidewall of the plasma generation chamber; an antenna coil disposed between the magnetic field coil and the outside of the sidewall and connected to a high-frequency power source; and means for introducing an etching gas disposed on top of the plasma generation chamber, wherein the sidewall is formed of a material having a relative dielectric constant of 4 or more.

## Description

### [Field of the Invention]

The present invention relates to a dry etching apparatus and a dry etching method.

### [Background Art]

In etching of an interlayer insulating film, for example, formed of SiO₂, covered with a resist mask, an inductively coupled dry etching method has been used. In the inductively coupled dry etching method, electrons are accelerated by an induction electric field generated by a high-frequency induction magnetic field, and the interlayer insulating film is etched in a plasma atmosphere formed by the electrons to form wiring holes and trenches by micromachining.

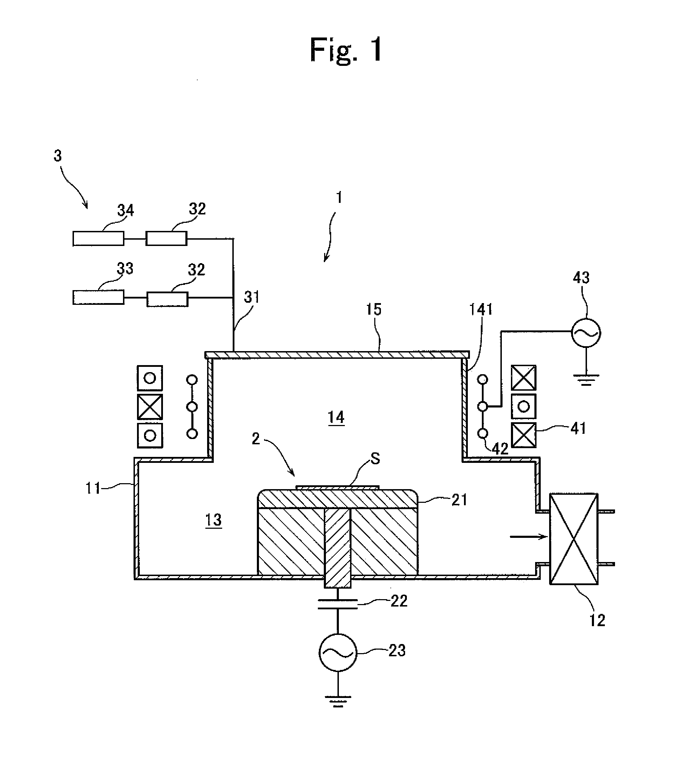

An inductively coupled dry etching apparatus is a known example of an apparatus with which such a dry etching method is performed (see, for example, Patent Document 1).
Patent Document 1: Japanese Patent Application Publication No. 2001-23961 (Claim 1 and Fig. 1)

### [Disclosure of Invention]

### [Problems to be Solved by the Invention]

However, the dry etching apparatus described above has an in-plane uniformity of 10% or more and an insufficient etching rate.

It is an object of the present invention to solve the problems of the prior art and provide a dry etching apparatus having excellent in-plane uniformity and a high etching rate.

### [Means for Solving the Problems]

A dry etching apparatus according to the present invention comprises a vacuum chamber including an upper plasma generation chamber and a lower substrate processing chamber; a magnetic field coil disposed outside a sidewall of the plasma generation chamber; an antenna coil disposed between the magnetic field coil and the outside of the sidewall and connected to a high-frequency power source; and means for introducing an etching gas disposed on top of the plasma generation chamber, wherein the sidewall is formed of a material having a relative dielectric constant of 4 or more. Because the material of the sidewall has a relative dielectric constant of 4 or more, which is higher than the relative dielectric constant (3.6) of quartz used for general dry etching apparatuses, an alternating electric field efficiently passes through the sidewall and increases the plasma density. This improves in-plane uniformity and increases etching rate.

Preferably, the material has a dielectric loss in the range of 1 x 10⁻⁴ to 10 x 10⁻⁴. At a dielectric loss above 10 x 10⁻⁴, part of an input alternating electric field heats a ceramic, and an increase in the temperature of the ceramic tends to make the etching process unstable. At a dielectric loss below 1 x 10⁻⁴, a sufficient improvement in in-plane uniformity and an increase in etching rate cannot be achieved.

Preferably, the material is a translucent ceramic. The term "translucent ceramic", as used herein, refers to a ceramic transparent to light having a wavelength in visible and infrared regions, that is, in the range of approximately 360 nm to 800 µm. Because a translucent ceramic has a high relative dielectric constant and a low dielectric loss, an alternating electric field can easily pass through a sidewall 141 formed of a translucent ceramic and increase the plasma density. High-density plasma can improve in-plane uniformity and etching rate.

Preferably, the translucent ceramic is one of a high-purity translucent alumina ceramic, a high-purity translucent yttria ceramic, and a high-purity translucent AlN ceramic. The term "high purity", as used herein, refers to a purity of 99.5% or more.

Preferably, yttria is thermally sprayed on the inner surface of the sidewall. Yttria can prevent etching of the inner surface of the sidewall and the generation of particles.

A dry etching method according to the present invention uses a dry etching apparatus described above and includes: introducing an etching gas into a vacuum chamber; forming a magnetic neutral line with a magnetic field coil; passing an alternating electric field from an antenna coil through a sidewall and applying an alternating potential along the magnetic neutral line to generate discharge plasma; and micromachining a substrate by etching.

### [Effect of the Invention]

A dry etching apparatus according to the present invention allows etching with excellent in-plane uniformity and a high etching rate.

### [Best Modes for Carrying Out the Invention]

Fig. 1 illustrates an etching apparatus 1 used for performing a method for dry-etching an interlayer insulating film according to the present invention. The etching apparatus 1 includes a vacuum chamber 11, which has evacuation means 12, such as a turbo-molecular pump.

The vacuum chamber 11 includes a lower substrate processing chamber 13 and an upper plasma generation chamber 14. A substrate table 2 is disposed at the center of the bottom of the lower substrate processing chamber 13. The substrate table 2 includes a substrate electrode 21, which is connected to a first high-frequency power source 23 via a blocking capacitor 22. The substrate electrode 21 acts as a floating electrode in terms of electric potential and has negative bias potential.

The substrate table 2 faces a top plate 15, which is disposed at the top of the plasma generation chamber 14 and which is fixed to the sidewall of the plasma generation chamber 14. The top plate 15 is connected to a gas-inlet line 31 of gas-inlet means 3, which introduce an etching gas into the vacuum chamber 11. The gas-inlet line 31 has two branches, which lead to a rare gas source 33 and a fluorocarbon gas source 34 via gas-flow control means 32.

The top plate 15 may include a shower plate for uniformly diffusing gas, connected to the gas-inlet means 3. The top plate 15 may be formed of silicon or provided with a silicon plate to improve etching rate.

The plasma generation chamber 14 includes a cylindrical sidewall 141. Preferably, the sidewall 141 is formed of a dielectric material and has a relative dielectric constant of 4 or more. The sidewall of the plasma generation chamber 14 is formed of a material having a dielectric constant higher than the relative dielectric constant of generally used quartz (3.6). This allows RF power to efficiently pass through the sidewall, thereby improving process consistency, etching rate, and process stability. In this case, the material having a relative dielectric constant of 4 or more preferably has a dielectric loss in the range of 1 x 10⁻⁴ to 10 x 10⁻⁴. A material having such characteristics is a translucent ceramic, for example. Among translucent ceramics, a high-purity translucent alumina ceramic or a high-purity translucent yttria ceramic has a relative dielectric constant as high as 10 or more and is preferred. A high-purity translucent AlN ceramic also has a high relative dielectric constant and is preferred.

In the case that the sidewall 141 is formed of a high-purity translucent ceramic, if the material of the sidewall is the same as an object to be etched, the inside of the sidewall may also be etched. In such a case, the inside of the sidewall 141 is preferably subjected to thermal spraying of yttria. Thermal spraying of yttria can prevent the sidewall to be etched.

A magnetic field coil 41 is disposed outside the sidewall 141 as means 4 for generating a magnetic field. The magnetic field coil 41 forms a magnetic neutral loop (not shown) in the plasma generation chamber 14.

A high-frequency antenna coil 42 for generating plasma is disposed between the magnetic field coil 41 and the outside of the sidewall 141 of the plasma generation chamber 14. The high-frequency antenna coil 42 has a parallel antenna structure and are constructed such that a voltage can be applied to the high-frequency antenna coil 42 by a second high-frequency power source 43. After a magnetic neutral line is formed by the magnetic field coil 41, an alternating electric field is applied along the magnetic neutral line to generate discharge plasma along the magnetic neutral line.

A mechanism for adjusting the voltage applied to the antenna coil to a predetermined voltage may be installed.

An etching apparatus thus constituted has a simple structure and can form high-efficiency plasma without mutual interference of applied high-frequency electric fields.

An etching apparatus for performing a dry etching method according to the present invention may include a Faraday shield-like (or electrostatic field shield-like) floating electrode (not shown) inside the high-frequency antenna coil 42. The Faraday shield is a known Faraday shield and is, for example, a metal plate that has a plurality of parallel slits and an antenna coil intersecting the slits at right angles at the longitudinal midpoints of the slits. A metallic frame for equalizing the electric potential of a strip of metal plate is disposed at each longitudinal end of the slits. The metal plate can shield against an electrostatic field of the antenna coil 42 but cannot shield against an induction magnetic field. The induction magnetic field enters plasma and forms an induction electric field. The width of the slits can be appropriately determined for each purpose and ranges from 0.5 to 10 mm, preferably 1 to 2 mm. Excessively wide slits unfavorably cause the penetration of an electrostatic field. The slits may have a thickness of approximately 2 mm.

A method for etching a substrate S to be processed with the etching apparatus 1 will be described below.

An object to be etched with the etching apparatus 1 may be those including a SiO₂ film, a film of a compound containing SiO₂, or a film formed of a material for optical elements, on a Si substrate.

Examples of the compound containing SiO₂ include TEOS-SiO₂, phosphosilicate glass, borophosphosilicate glass, rare-earth-doped glass, and low-expansion crystallized-glass. Examples of the material for optical elements include lithium niobate, lithium tantalate, titanium oxide, tantalum oxide, and bismuth oxide.

The substrate may include a SiOCH material film formed by spin coating, such as HSQ or MSQ, a Low-k material film, which is formed of a SiOC material and is formed by CVD and has a relative dielectric constant in the range of 2.0 to 3.2, or a porous material film.

Examples of the SiOCH material include LKD5109r5 (trade name) manufactured by JSR Co., HSG-7000 (trade name) manufactured by Hitachi Chemical Co., Ltd., HOSP (trade name) manufactured by Honeywell Electric Materials, Nanoglass (trade name) manufactured by Honeywell Electric Materials, OCD T-12 (trade name) manufactured by Tokyo Ohka Kogyo Co., Ltd., OCD T-32 (trade name) manufactured by Tokyo Ohka Kogyo Co., Ltd., IPS2.4 (trade name) manufactured by Catalysts & Chemicals Industries Co., Ltd., IPS2.2 (trade name) manufactured by Catalysts & Chemicals Industries Co., Ltd., ALCAP-S5100 (trade name) manufactured by Asahi Kasei Co., and ISM (trade name) manufactured by ULVAC, Inc.

Examples of the SiOC material include Aurola2.7 (trade name) manufactured by ASM Japan K.K., Aurola2.4 (trade name) manufactured by ASM Japan K.K., Orion2.2 (trade name) manufactured by Fastgate Co. and Trikon Technologies Inc., Coral (trade name) manufactured by Novellus Systems Inc., Black Diamond (trade name) manufactured by Applied Materials, Inc. (AMAT), and NCS (trade name) manufactured by Fujitsu Ltd. Examples of the SiOC material also include SiLK (trade name) manufactured by The Dow Chemical Company, Porous-SiLK (trade name) manufactured by The Dow Chemical Company, FLARE (trade name) manufactured by Honeywell Electric Materials, Porous FLARE (trade name) manufactured by Honeywell Electric Materials, and GX-3P (trade name) manufactured by Honeywell Electric Materials.

Examples of a mask material for a substrate to be etched include organic materials, such as KrF resist materials and ArF resist materials, and known metallic materials, such as Ni.

A substrate S to be processed on which a mask is placed on a substrate table 2. An etching gas is then introduced from means 4 for introducing an etching gas, and RF power is applied by a second high-frequency power source 43 to generate plasma in a plasma generation chamber 14, thereby etching the substrate S.

Examples of the etching gas include gases that contains a fluorocarbon gas and at least one gas selected from rare gases, such as Ar, Xe, and Kr. Examples of the fluorocarbon gas include CF₄, C₂F₆, C₄F₈, and C₃F₈. In particular, C₄F₈ and C₃F₈ are preferred. In this case, the rare gas is introduced by the gas-flow control means 32 such that the rare gas constitutes 80% to 95% of the total flow rate of the etching gas. The etching gas is introduced in a plasma atmosphere into a vacuum chamber 11 at an operating pressure of 1 Pa or less and a flow rate of 100 to 300 sccm, and etching is performed.

According to a dry etching method using such a dry etching apparatus 1, the in-plane uniformity and etching rate can be improved as compared with a dry etching apparatus.

### EXAMPLE 1

In the present example, etching was performed with an etching apparatus 1 illustrated in Fig. 1. A sidewall 141 was formed of a translucent alumina ceramic, SAPPHAL (trade name) manufactured by Toshiba Ceramics Co., Ltd. (relative dielectric constant: 10, dielectric loss: 1 x 10⁻⁴).

A Si substrate S to be processed on which a SiO₂ film having a thickness of 1 µm was formed was placed on a substrate table 2 of the etching apparatus 1 in which the sidewall 141 of the plasma generation chamber 14 was formed of high-purity translucent alumina. Plasma was generated by a second high-frequency power source 43, and an etching gas composed of 8 sccm of C₃F₈ and 152 sccm of Ar gas was introduced, thereby the substrate S to be processed was etched. Etching conditions included a first high-frequency power source (substrate side) 400 W, a second high-frequency power source (antenna side) 1200 W, a substrate set temperature of -20°C, and a pressure of 0.6 Pa.

After introducing the etching gas and etching the substrate S to be processed for 1 minute, the substrate S to be processed was removed from the etching apparatus 1. The in-plane uniformity was determined to be ±4.79%. The etching rate was determined to be 134 nm/min.

### (COMPARATIVE EXAMPLE 1)

Etching was performed as in Example 1, except that the sidewall 141 of the plasma generation chamber 14 was formed of quartz (relative dielectric constant 3.6, dielectric loss 3 x 10⁻³). After a substrate S to be processed was removed from the etching apparatus, the in-plane uniformity was determined to be ±10.28%. The etching rate was determined to be 94.1 nm/min.

### EXAMPLE 2

In the present example, etching was performed as in Example 1, except that a G-line resist having a thickness of 2 µm was formed as a resist. After a substrate S was removed from the etching apparatus 1, the in-plane uniformity was determined to be ±9.58%. The etching rate was determined to be 79.5 nm/min.

### (COMPARATIVE EXAMPLE 2)

Etching was performed as in Example 2, except that the sidewall 141 of the plasma generation chamber 14 was formed of quartz (relative dielectric constant 3.6, dielectric loss 3 x 10⁻³). After a substrate S was removed from the etching apparatus, the in-plane uniformity was determined to be ±36.14%. The etching rate was determined to be 66.7 nm/min.

According to the above-described results, when the sidewall of the plasma generation chamber was formed of a translucent ceramic, the in-plane uniformity of etching and the etching rate were improved. The in-plane uniformity and the etching rate were substantially consistent, independent of the resist material, indicating improved stability of the process.

### EXAMPLE 3

In the present example, etching was performed as in Example 1, except that the Si substrate was substituted by a sapphire substrate. After a substrate S to be processed was removed from the etching apparatus 1, the in-plane uniformity was determined to be ±5%. The etching rate was determined to be 350 nm/min.

### EXAMPLE 4

In the present example, etching was performed as in Example 1, except that the inner surface of the sidewall 141 of the etching apparatus 1 used in Example 1 was subjected to thermal spraying of yttria (thickness of 250 µm) and that the substrate was a sapphire substrate. After a substrate S to be processed was removed from the etching apparatus 1, the in-plane uniformity was determined to be ±5%. The etching rate was determined to be 350 nm/min.

In Example 3, because the object to be etched and the material of the sidewall were the same, the sidewall 141 was sometimes etched during an extended period of etching. In Example 4, although the object to be etched and the material of the sidewall were the same, the sidewall 141 was not etched. This suggests that, even if an object to be etched and the material of a sidewall are the same, thermal spraying of yttria on the inside of a sidewall 141 of a plasma generation chamber allows etching with excellent in-plane uniformity and a high etching rate.

### EXAMPLE 5

In the present example, etching was performed as in Example 1, except that the sidewall 141 was formed of a high-purity translucent yttria ceramic (relative dielectric constant: 11.3, dielectric loss: 5.5 x 10⁻⁴). After a substrate S to be processed was removed from the etching apparatus 1, the in-plane uniformity was determined to be ±8%. The etching rate was determined to be 300 nm/min.

### EXAMPLE 6

In the present example, etching was performed as in Example 1, except that the sidewall 141 was formed of a high-purity translucent AlN ceramic (relative dielectric constant: 9.1, dielectric loss: 2.5 x 10⁻⁴). After a substrate S to be processed was removed from the etching apparatus 1, the in-plane uniformity was determined to be ±7%. The etching rate was determined to be 330 nm/min.

### [Industrial Applicability]

According to a dry etching apparatus of the present invention, etching can be performed with excellent in-plane uniformity and a high etching rate. Thus, the present invention can be utilized in the semiconductor technical field.

### [Brief Description of Drawing]

Fig. 1 is a schematic view of a dry etching apparatus according to the present invention.

### [Description of Reference Numerals]

- 1: etching apparatus
- 2: substrate table
- 3: etching gas-inlet means
- 4: means for generating plasma
- 11: vacuum chamber
- 12: evacuation means
- 13: substrate processing chamber
- 14: plasma generation chamber
- 15: top plate
- 21: substrate electrode
- 22: blocking capacitor
- 23: high-frequency power source
- 31: gas-inlet line
- 32: gas-flow control means
- 33: rare gas source
- 34: fluorocarbon gas source
- 41: magnetic field coil
- 42: antenna coil
- 42: high-frequency antenna coil
- 43: high-frequency power source
- 141: sidewall
- S: substrate to be processed

## Claims

1. A dry etching apparatus comprising:
a vacuum chamber including an upper plasma generation chamber and a lower substrate processing chamber;
a magnetic field coil disposed outside a sidewall of the plasma generation chamber;
an antenna coil disposed between the magnetic field coil and the outside of the sidewall and connected to a high-frequency power source; and
means for introducing an etching gas disposed on top of the plasma generation chamber, wherein the sidewall is formed of a material having a relative dielectric constant of 4 or more.

2. The dry etching apparatus according to claim 1, wherein the material has a dielectric loss in the range of 1 x 10⁻⁴ to 10 x 10⁻⁴.

3. The dry etching apparatus according to claim 1 or 2, wherein the material is a translucent ceramic.

4. The dry etching apparatus according to claim 3, wherein the translucent ceramic is one of a high-purity translucent alumina ceramic, a high-purity translucent yttria ceramic, and a high-purity translucent AlN ceramic.

5. The dry etching apparatus according to any one of claims 1 to 4, wherein an inner surface of the sidewall is subjected to thermal spraying of yttria.

6. A dry etching method using a dry etching apparatus according to any one of claims 1 to 5, comprising:
introducing an etching gas into a vacuum chamber;
forming a magnetic neutral line with a magnetic field coil;
passing an alternating electric field from an antenna coil through a sidewall and applying an alternating potential along the magnetic neutral line to generate discharge plasma; and
micromachining a substrate by etching.
